# EUROPEAN PATENT APPLICATION

(11) **EP 4 768 625 A1**
(43) Date of publication of application: **01.07.2026**
(21) Application number: 25220293.2
(22) Date of filing: 03.12.2025
(51) Int. Cl.: C23C 16/44, C23C 16/455, F16L 23/032, F16L 23/20

(54) **INJECTOR APPARATUS, SEMICONDUCTOR PROCESSING SYSTEMS INCLUDING INJECTOR APPARATUS, AND METHODS OF DEPOSITING MATERIAL LAYERS ONTO WORKPIECES USING SEMICONDUCTOR PROCESSING SYSTEMS AND INJECTOR APPARATUS**

(30) Priority: 06.12.2024 US 202463728940 P
(71) Applicant: ASM IP Holding B.V., 1322 AP Almere (NL)
(72) Inventor: Wiegers, Frans, 1322 AP Almere (NL)
(74) Representative: V.O.

(57) **Abstract**

An injector apparatus includes an injector holder, a reactor flange, a coupling member, a connector body, and at least one protrusion. The injector holder includes an injector collar having a first injector collar end, a second injector collar end, and an injector rim coupled to the first injector collar end. The injector rim defining an injection aperture. The reactor flange includes a tube member having a first tube member end, a second tube member end, and a reactor rim coupled to the first tub member end. The reactor rim defining a reactor aperture. The coupling member fluidly couples the reactor flange to the injector holder and defines a precursor aperture. The connector body mechanically couples the injector holder to the reactor flange. The protrusion may include an injector protrusion and a reactor protrusion. Semiconductor processing systems including the injector apparatus and material layer deposition methods are also described.

## Description

### FIELD OF INVENTION

The present disclosure generally relates to gaskets, and more particularly to gaskets used in the deposition of a material layer onto a workpiece.

### BACKGROUND OF THE DISCLOSURE

Gaskets are commonly used to fill a space between two or more surfaces, and are generally intended to prevent leakage when compressed. The gasket may be made from rubber, metal, or a polymer material, and come in a variety of sizes and shapes. In the case of semiconductor device fabrication, gaskets may generally be used to prevent leakage from a container holding a chemistry to a tool in which the chemistry will be introduced into. In the case of semiconductor device fabrication, a gasket may generally be an O-ring shape and be manufactured out of a material that is suitable for a range of chemistries, temperatures, and pressures. O-rings are generally employed to seal the connection between two surfaces, such as between chemical vessels and supply conduits for the introduction of chemistries into the semiconductor device fabrication tool.

Such methods and systems have generally been considered suitable for their intended purpose. However, there remains a need in the art for improved gasket material selection, semiconductor processing systems including gasket material selection and material deposition methods. The present disclosure provides a solution to this need.

### SUMMARY OF THE DISCLOSURE

An injector apparatus is provided. The injector apparatus includes an injector holder, an injector, a reactor flange, a coupling member, a connector body, and at least one of a injector protrusion and a reactor protrusion. The injector holder includes an injector collar, which includes a first injector collar end and a second injector collar end, and an injector rim coupled to the first injector collar end. The injector rim further defines an injection aperture. The injector is slidably received into the second injector collar end. The reactor flange includes a tube member, which includes a first tube member end and a second tube member end, and a reactor rim coupled to the first tube member end. The reactor rim further defines a reactor aperture. The coupling member fluidly couples the reactor flange to the injector holder and defines a precursor aperture. The connector body is configured to mechanically couple the injector holder to the reactor flange. The injector apparatus includes at least one of an injector protrusion and a reactor protrusion. The injector protrusion extends from the injector rim and is about the injection aperture. The reactor protrusion extends from the reactor rim and is about the reactor aperture.

In addition to one or more of the features described above, or as an alternative, further examples of the injector apparatus may include the injector protrusion and the reactor protrusion.

In addition to one or more of the features described above, or as an alternative, further examples of the injector apparatus may include the injector rim further defining a plurality of longitudinal apertures radially outward of the injector protrusion. The reactor rim may define a plurality of longitudinal recesses radially outward of the reactor protrusion. The connector body may be seated in the injector rim, slidably received by the plurality of the longitudinal apertures, and couple to the plurality of longitudinal recesses.

In addition to one or more of the features described above, or as an alternative, further examples of the injector apparatus may include the injector rim further defining a plurality of longitudinal recesses radially outward of the injector protrusion. The reactor rim may define a plurality of longitudinal apertures radially outward of the reactor protrusion. The connector body may be seated in the reactor rim, slidably received by the plurality of longitudinal apertures, and couple to the plurality of longitudinal recesses.

In addition to one or more of the features described above, or as an alternative, further examples of the injector apparatus may include the injector holder includes or is formed from a refractory material and the reactor flange includes or is formed from a refractory material.

In addition to one or more of the features described above, or as an alternative, further examples of the injector apparatus may include the coupling member includes or is formed from a malleable material.

In addition to one or more of the features described above, or as an alternative, further examples of the injector apparatus may include the connector body is one of a plurality of connector bodies and includes or is formed from a refractory material.

An injector holder is provided. The injector holder includes an injector collar, an injector rim, and an injector protrusion. The injector collar further includes a first injector collar end and a second injector collar end. The injector rim is coupled to the first injector collar end and defines an injection aperture. The injector protrusion extends from the injector rim and is about the injection aperture.

In addition to one or more of the features described above, or as an alternative, further examples of the injector holder may include an injector slidably received by the second injector collar end of the injector holder.

In addition to one or more of the features described above, or as an alternative, further examples of the injector holder may include the injector rim defining a plurality of longitudinal apertures radially outward of the injector protrusion.

In addition to one or more of the features described above, or as an alternative, further examples of the injector holder may include the injector rim defining a plurality of longitudinal recesses radially outward of the injector protrusion.

In addition to one or more of the features described above, or as an alternative, further examples of the injector holder may include the injector holder includes or is formed from a refractory material.

A reactor flange is provided. The reactor flange includes a tube member, a reactor rim, and a reactor protrusion. The tube member further includes a first tube member end and a second tube member end. The reactor rim is coupled to the first tube member end of the tube member and defines a reactor aperture. The reactor protrusion extends from the reactor rim and is about the reactor aperture.

In addition to one or more of the features described above, or as an alternative, further examples of the reactor flange may include a precursor source fluidly coupled to the second tube member end of the reactor flange.

In addition to one or more of the features described above, or as an alternative, further examples of the reactor flange may include the reactor rim further defining a plurality of longitudinal recesses radially outward of the reactor protrusion.

In addition to one or more of the features described above, or as an alternative, further examples of the reactor flange may include the reactor rim further defining a plurality of longitudinal apertures radially outward of the reactor protrusion.

In addition to one or more of the features described above, or as an alternative, further examples of the reactor flange may include the reactor flange includes or is formed from a refractory material.

A semiconductor processing system is provided. The semiconductor processing system includes the injector apparatus as described above, a precursor source, a chamber body, an exhaust source, a substrate support, a workpiece, and a controller. The precursor source is fluidly coupled to the second tube member end of the injector apparatus. The chamber body includes a hollow interior. The exhaust source is fluidly coupled to the chamber body and is fluidly coupled to the precursor source through the chamber body. The substrate support is positioned within the hollow interior of the chamber body, and the workpiece is supported on the substrate support. The controller is operatively connected to the precursor source, is disposed in communication with the precursor source, and is responsive to instructions recorded on a memory to deposit a material layer onto the workpiece.

A material layer deposition method is provided. The method includes, at a semiconductor processing system including an injector apparatus as described above, seating the workpiece within the interior of the chamber body, heating the workpiece to a predetermined material layer deposition temperature, exposing the workpiece to a material layer precursor, and depositing the material layer onto the workpiece using the material layer precursor.

In addition to one or more of the features described above, or as an alternative, further examples of the material layer deposition method may include placing a substrate support within the interior of the chamber body where the workpiece is seated on the substrate support and the workpiece is a substrate.

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE DRAWING FIGURES

These and other features, aspects, and advantages of the invention disclosed herein are described below with reference to the drawings of certain embodiments, which are intended to illustrate and not to limit the invention.
FIG. 1 is a schematic view of a semiconductor processing system in accordance with the present disclosure, showing an injector apparatus positioned within a chamber arrangement for deposition of a material layer onto a substrate;
FIG. 2 is a longitudinal cross-sectional view of a portion of the semiconductor processing system of FIG. 1 according to an example of the disclosure, showing the injector apparatus coupled to an injector and a precursor source;
FIGS. 3 and 4 are longitudinal cross-sectional and exploded views of the injector apparatus of FIG. 1 according to an example of the disclosure, showing elements of the injector apparatus;
FIGS. 5 and 6 are partial lateral cross-sectional and exploded views of the injector apparatus of FIG. 1 according to an example of the disclosure, showing elements of the injector apparatus;
FIG. 7 is a block diagram of a method of depositing a material layer onto a workpiece according to the present disclosure, showing the operations of the method according to an illustrative and non-limiting example of the method.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION OF EXEMPLARY EMBODIMENTS

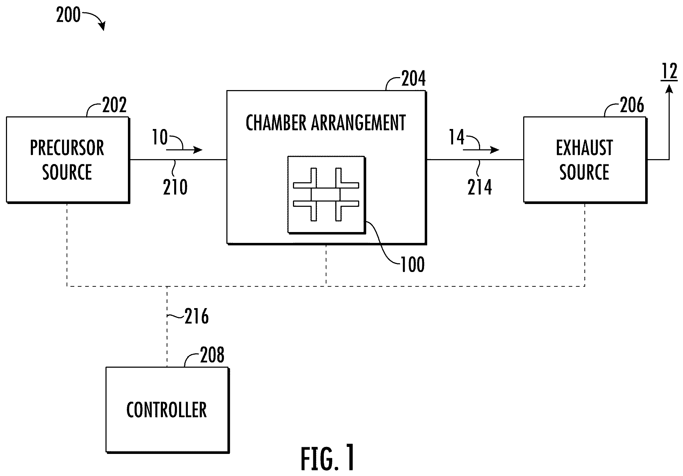

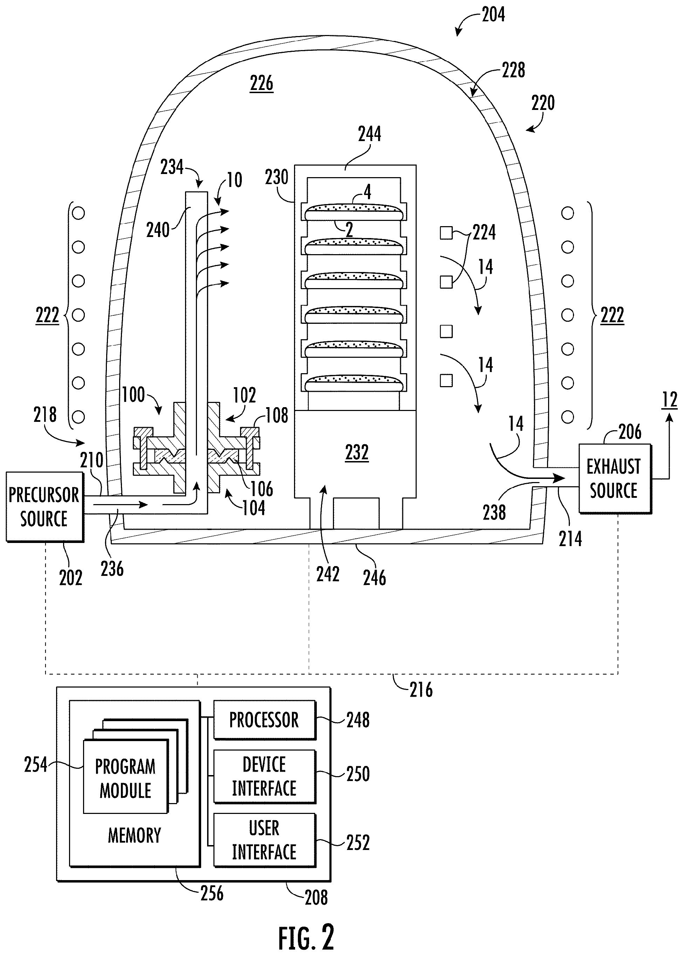

Reference will now be made to the drawings wherein like reference numerals identify similar structural features or aspects of the subject disclosure. For purposes of explanation and illustration, and not limitation, a partial view of an example of a chamber arrangement including an injector apparatus in accordance with the present disclosure is shown in FIG. 1 and is designated generally by reference character 100. Other examples of injector apparatuses, semiconductor processing systems and chamber arrangements including injector apparatuses, and a method of depositing a material layer onto a substrate using an injector apparatus in accordance with the present disclosure, or aspects thereof, are provided in FIGS. 2-7, as will be described. The apparatus, system, and methods of the present disclosure may be used for fluidly coupling a material layer precursor source to a hollow interior of a semiconductor processing system employed for depositing material layers onto substrates and/or removing material from substrates, such as during the fabrication of memory or logic semiconductor devices using atomic layer deposition and/or chemical vapor deposition techniques, though the present disclosure is not limited to the fabrication of any particular semiconductor device or to any particular device fabrication operation in general.

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below

Referring to FIG. 1, a semiconductor processing system 200 including the injector apparatus 100 is shown. The semiconductor processing system 200 includes a precursor source 202, a chamber arrangement 204 including the injector apparatus 100, an exhaust source 206, and a controller 208. The precursor source 202 is fluidly coupled to the chamber arrangement 204 by a precursor supply conduit 210, includes a material layer precursor 10, and is configured to communicate a flow of the material layer precursor 10 to the chamber arrangement 204. The chamber arrangement 204 includes a substrate support 230 (as shown in FIG. 2), is coupled to the exhaust source 206 by an exhaust conduit 214, and is configured to expose a substrate 2 (as shown in FIG. 2) seated on the substrate support 230 to the material layer precursor 10 under environmental conditions (e.g., pressure and/or temperature) selected to cause a material layer 4 to deposit onto the substrate 2. The exhaust source 206 is in communication with an external environment 12 outside of the semiconductor processing system 200 and is configured to communicate a flow of residual precursor and/or reaction products 14 issued by the chamber arrangement 204 during deposition of the material layer 4 (as shown in FIG. 2) onto the substrate 2, for example using a vacuum pump and an abatement device like a scrubber. The controller 208 is operably connected to one or more elements of the semiconductor processing system 200, e.g., the precursor source 202 to control the flow of the material layer precursor 10 through the injector apparatus 100 during the deposition of the material layer 4 onto the substrate 2 and in this respect may be coupled thereto by a wired or wireless link 216.

In certain examples, the precursor source 202 may be configured to communicate one or more silicon-containing material layer precursor within the material layer precursor 10 communicated to the chamber arrangement 204. Examples of suitable material layer precursors include non-chlorinated silicon-containing material layer precursors silane (SiH₄) or disilane (Si₂H₆) and/or a halogenated, e.g. chlorinated silicon-containing material layer precursor such as dichlorosilane (H₂SiCl₂) or trichlorosilane (HCl₃Si). Other material layer precursors may include metallic precursors, organometallic precursors, and halides. In some embodiments, a material layer precursor may comprise one or more elements selected from hydrogen, an alkaline metal, an alkaline earth metal, a transition metal, a lanthanide, a post transition metal, a group 13 element, a group 14 element, a chalcogen, a pnictogen, a halogen, and a noble gas.

In accordance with certain examples, the precursor source 202 may be configured to communicate a dopant-containing material layer precursor and/or an alloying constituent within the material layer precursor 10 to the chamber arrangement 204. Examples of suitable dopant-containing material layer precursors include n-type dopant-containing material layer precursors, such as compounds containing phosphorous (P) or arsine (As), as well as p-type dopant-containing material layer precursors like compounds containing boron (B); examples of suitable alloying constituents include germanium-containing compounds, such as germane (GeH₄) by way of non-limiting example.

It is contemplated that the precursor source 202 may be configured to communicate an etchant to the chamber arrangement 204, which may be co-flowed with the material layer precursor 10 or provided as a separate flow to the chamber arrangement 204. Examples of suitable etchants include halogen-containing compounds such as hydrochloric (HCl) acid and chlorine (Cl₂) gas as well as fluorine-containing compounds like hydrofluoric (HF) acid. It is also contemplated that the precursor source 202 may be configured to communicate a diluent or carrier fluid (e.g., a gas) to the chamber arrangement 204. For example, the precursor source 202 may be configured to communicate one or more of hydrogen (H₂) gas, nitrogen (N₂) gas, a noble gases, or a mixtures including one or more of the aforementioned gases. The carrier or diluent fluid may be communicated to the chamber arrangement 204 with the material layer precursor 10 or separately, such as a purge fluid flow.

As used herein, the term "substrate" may refer to any underlying material or materials, including any underlying material or materials that may be modified, or upon which, a device, a circuit, or a film may be formed. A "substrate" may be continuous or non-continuous; rigid or flexible; solid or porous; and combinations thereof. A substrate may be in any form, such as a powder, a plate, or a workpiece. A substrate may be made from semiconductor materials, including, for example, silicon (Si), silicon germanium (SiGe), silicon oxide (SiO₂), gallium arsenide (GaAs), gallium nitride (GaN) and silicon carbide (SiC). As examples, a substrate in the form of a powder may have applications for pharmaceutical manufacturing. A porous substrate may comprise polymers. Examples of workpieces may include medical devices (for example, stents and syringes), jewelry, tooling devices, cutlery, fasteners (for example, screws, nails, or bolts), components for battery manufacturing (for example, anodes, cathodes, or separators) or components of photovoltaic cells, etc. A continuous substrate may extend beyond the bounds of a process chamber where a deposition process occurs. In some processes, the continuous substrate may move through the process chamber such that the process continues until the end of the substrate is reached. A continuous substrate may be supplied from a continuous substrate feeding system to allow for manufacture and output of the continuous substrate in any appropriate form. Non-limiting examples of a continuous substrate may include a sheet, a non-woven film, a roll, a foil, a web, a flexible material, a bundle of continuous filaments or fibers (for example, ceramic fibers or polymer fibers). Continuous substrates may also comprise carriers or sheets upon which non-continuous substrates are mounted.

With reference to FIG. 2, the semiconductor processing system 200 including the injector apparatus 100 is shown according to an example of the present disclosure. In the illustrated example the chamber arrangement 204 has a multiple substrate architecture 218 and includes a chamber body 220, an array of heating elements 222, and one or more temperature sensors 224. The one or more temperature sensors 224 may be positioned within the chamber body 220 to monitor and communicate with the controller 208 the temperature of the chamber body 220 and/or multiple substrates 2 of the multiple substrate architecture 218. In certain examples, the one or more temperature sensors 224 may be thermocouples, pyrometers, or a combination thereof. The array of heating elements 222 may surround the chamber body 220, and may be used to heat multiple substrates 2 to a predetermined temperature for deposition of a material layer 4. The array of heating elements 222 may be in communication with the one or more temperature sensors 224 by the controller 208, and the controller 208 may adjust the power supplied (not shown) to the array of heating elements 222 based on the signal communicated from the one or more temperature sensors 224. In certain examples, the array of heating elements 222 may be include a plurality of filament-type heater elements, such as linear lamps. In accordance with certain examples, the array of heating elements 222 may include a plurality of bulb-type heater elements. In accordance with certain examples, the array of heating elements 222 may include a combination of both filament-type heater elements as well as bulb-type heater elements and remain within the scope of the present disclosure.

The chamber body 220 has a hollow interior 226, and may be generally bell jar shaped. The chamber body 220 has a supply aperture 236 and an exhaust aperture 238. The supply aperture 236 fluidly couples the chamber body 220 to the precursor supply conduit 210, while the exhaust aperture 238 fluidly couples the chamber body 220 to the exhaust conduit 214. In this regard, the precursor source 202 is fluidly coupled to the exhaust source 206 by way of the chamber body 220. It is contemplated that the chamber body 220 may be formed from a ceramic material 228. In certain examples, the ceramic material 228 may be a transparent material, such as a material transparent to electromagnetic radiation within an infrared waveband like quartz or sapphire.

The hollow interior 226 of the chamber body 220 may further include the injector apparatus 100, the substrate support 230, a pedestal 232, a moveable door 246, and an injector 234. The injector apparatus 100 may be configured to support the injector 234 within the hollow interior 226 of the chamber body 220 and in this respect may include an injector holder 102, a reactor flange 104, a coupling member 106, and a connector body 108. The injector 234 is coupled the injector apparatus 100 on a first end of the injector 234. The injector 234 fluidly communicates the material layer precursor 10 into the hollow interior 226 of the chamber body 220 for depositing a material layer 4 on to the multiple substrates 2 from a second end of the injector 234. In certain examples the injector 234 may be formed from a refractory material 240. It is contemplated that the injector 234 may be formed from a ceramic material. In certain examples the injector 234 may be formed from silicon carbide (SiC), silicon (Si), or quartz by way of a non-limiting examples. The moveable door 246 supports the pedestal 232 and the substrate support 230 within the hollow interior 226 of the chamber body 220. The moveable door 246 allows for the substrate support 230 to be inserted into the hollow interior 226 of the chamber body 220 from outside of the chamber body 220 or removed from the hollow interior 226 of the chamber 220 to outside of the chamber body 220. The substrate support 230 is supported within the hollow interior 226 of the chamber body 220 by the pedestal 232, and may be configured to support multiple substrates 2. The substrate support 230 may be configured to support, for example, 100 substrates, 120 substrates, 150 substrates, 170 substrates, or greater than 170 substrates. In certain examples the substrate support 230 may be formed from a refractory material 244. It is contemplated that the substrate support 230 may be formed from a ceramic material. In certain examples the substrate support 230 may be formed from silicon carbide (SiC), silicon (Si), or quartz by way of a non-limiting examples.

The pedestal 232 supports the substrate support 230 within the hollow interior 226 of the chamber body 220. In accordance with certain examples, a workpiece may be supported only by the pedestal 232 within the hollow interior 226 of the chamber body 220 and remain within the scope of the present disclosure. In these examples the workpiece may not be a substrate 2, but may be a component for aerospace, automotive, or other applications that may benefit from a material layer being deposited onto the workpiece. As will be appreciated by those skilled in the art, placing the workpiece directly on the pedestal 232 would allow for a larger dimensioned workpiece to receive a material layer to be deposited onto the workpiece. In accordance with certain examples, a workpiece may be supported by the pedestal 232 and an alternative support mechanism within the hollow interior 226 of the chamber body 220, and may be a workpiece for aerospace, automotive, or other applications that may benefit from a material layer being deposited onto the workpiece. In certain examples the pedestal 232 may be formed from a refractory material 242. It is contemplated that the pedestal 232 may be formed from a ceramic material. In certain examples the pedestal 232 may be formed from silicon carbide (SiC), silicon (Si), or quartz by way of a non-limiting examples.

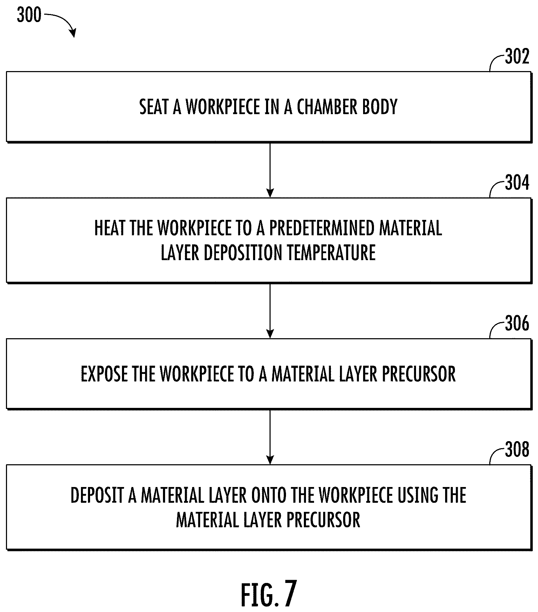

The controller 208 may be configured to control one or more elements of the semiconductor processing system 200. The controller 208 may include a processor 248, a device interface 250, a user interface 252, a plurality of program modules 254, and a memory 256. The device interface 250 may couple the controller 208 to precursor source 202 via the wired or wireless link 216 and/or other elements of the semiconductor processing system 200 and is coupled to the processor 248. The processor 248 is coupled to the device interface 250, is operably coupled to the user interface 252 to receive user input and/or provide user output therethrough, and is disposed in communication with the memory 256. The memory 256 includes a non-transitory machine-readable medium having a plurality of program modules 254 recorded thereon containing instructions that, when read by the processor 248, cause the processor 248 to execute certain operations. Among the operations are operations of a material layer deposition method 300 (as shown in FIG. 7), as will be described. Although described herein as having a specific architecture, it is to be understood and appreciated that the controller 208 can have different architectures in other examples of the present disclosure (e.g., a distributed computing architecture), and remain within the scope of the present disclosure. For example, the controller 208 may be configured to control the volume of the material layer precursor 10 flowing into the injector apparatus 100 from the precursor source 202. The controller 208 may be configured to adjust the array of heating elements 222 in response to a signal received from the one or more temperature sensors 224 which are in communication with the controller 208. The controller 208 may be configured to open and close the moveable door 246 of the chamber body 220. The controller 208 may be configured to remove excess precursor from the hollow interior 226 of the chamber body 220 to the external environment 12 by the exhaust source 206.

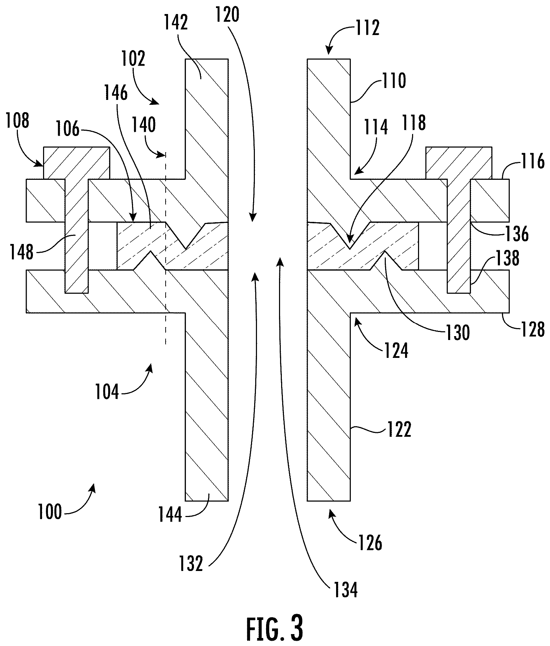

With reference to FIGS. 3-6, the injector apparatus 100 is shown according to an example of the present disclosure. The injector apparatus 100 may be configured to support the injector 234 within the hollow interior 226 of the chamber body 220 (as shown in FIG. 2) and in this respect may include the injector holder 102, the reactor flange 104, the coupling member 106, and the connector body 108.

A longitudinal cross-sectional view of the injector apparatus 100 is shown in FIG. 3. The injector holder 102 may include an injector collar 110 with a first injector collar end 112 and a second injector collar end 114, an injector rim 116, and an injector protrusion 118. The first injector collar end 112 of the injector collar 110 slidably receives the injector 234 (as shown in FIG. 2). The injector rim 116 is coupled to the second injector collar end 114 of the injector collar 110 and defines an injection aperture 120. The injector rim 116 further defines a plurality of longitudinal apertures 136 radially outward of the injection aperture 120. The injector protrusion 118 extends from the injector rim 116, and is circumferential about the injection aperture 120. In the illustrated example the injector protrusion 118 is radially inward of the longitudinal apertures 136. In certain examples, the injector protrusion 118 may be radially outward of the longitudinal apertures 136. In the illustrated example, the injector protrusion 118 forms a single acute angle. In certain examples, the injector protrusion 118 may form an obtuse angle, may form a ninety (90) degree angle with respect to the coupling member 106, may be rounded, or may consist of one or more of the aforementioned geometries and remain within the scope of the present disclosure. As will be appreciated by those skilled in the art these geometries provide flexibility based upon the environmental conditions selected to deposit a material layer 4 onto the substrate 2. In certain examples the injector holder 102 may be formed from a refractory material. It is contemplated that the injector holder 102 may be formed from a ceramic material 142. In certain examples, the injector holder 102 may be formed from silicon carbide (SiC), silicon (Si), or quartz by way of a non-limiting examples.

The reactor flange 104 may include a tube member 122 with a first tube member end 124 and a second tube member end 126, a reactor rim 128, and a reactor protrusion 130. The reactor rim 128 is coupled to the first tube member end 124 of the tube member 122 and defines a reactor aperture 132. The reactor rim 128 further defines a plurality of longitudinal recesses 138 radially outward of the reactor aperture 132. The second tube member end 126 of the tube member 122 is coupled to the supply conduit 210 (as shown in FIG. 2). Similar to the injector holder 102, the reactor flange 104 may be formed from a refractory material. In certain examples the reactor flange 104 may be formed from a ceramic material 144. It is contemplated that the reactor flange 104 may be formed from silicon carbide (SiC), silicon (Si), or quartz by way of a non-limiting examples. The reactor protrusion 130 is similar to the injector protrusion 118, and extends from the reactor rim 128. The reactor protrusion 130 is circumferential about the reactor aperture 132 and radially inward of the plurality of longitudinal recesses 138. In certain examples the reactor protrusion 130 is radially outward of the plurality of longitudinal recesses 138.

As will be appreciated by those skilled in the art, in some embodiments, one or more of the injector holder 102, the reactor flange 104, and the injector 234 may be formed from the same material. In some embodiments, two or more of the injector holder 102, the reactor flange 104, and the injector 234 may be formed from the same material. In some embodiments, all of the injector holder 102, the reactor flange 104, and the injector 234 may be formed from the same material. In some embodiments, at least one of the injector holder 102, the reactor flange 104, and the injector 234 comprises silicon.

In the illustrated example the reactor protrusion 130 is closer in proximity to the connector body 108 than the injector protrusion 118. As will be appreciated by those skilled in the art, the reactor protrusion 130 may be an equal distance or further from the connector body 108 than the injector protrusion 118. Although shown and described herein as having the same geometries it is to be understood and appreciated that both the injector protrusion 118 and the reactor protrusion 130 may have different geometries and remain within the scope of the present disclosure. In certain examples one of either the injector protrusion 118 or the reactor protrusion 130 may be absent and remain within the scope of the present disclosure. In the illustrated example, the injector protrusion 118 and the reactor protrusion 130 are not vertically aligned along a vertical dashed line 140. In certain examples both, one of either, part of either, or a combination thereof, the injector protrusion 118 or the reactor protrusion 130 may be aligned along the vertical dashed line 140 and still remain within the scope of the present disclosure. In certain examples where the geometries of the injector protrusion 118 and reactor protrusion 130 are different, all of, part of, or none of the different geometries may align along the vertical dashed line 140 and still remain within the scope of the present disclosure.

The coupling member 106 is positioned between the injector holder 102 and reactor flange 104 and defines a precursor aperture 134. Along with the injector holder 102 and the reactor flange 104, the coupling member 106 provides a sealing mechanism for the flow of the material layer precursor 10 from the precursor source 202 to the injector 234 after the material layer precursor 10 has flowed through the supply aperture 236 and precursor supply conduit 210 (as shown in FIG. 2). The sealing mechanism is further assisted by the injector protrusion 118 and the reactor protrusion 130. It is contemplated that the coupling member 106 may be formed from a malleable material 146. The malleable material 146 may be a material that is able to deform without fracturing while undergoing compressive forces. It is contemplated that the coupling member 106 may be formed from softer metallic materials, such as nickel (Ni), palladium (Pd), platinum (Pt), titanium (Ti), and cadmium (Cd), other transition metal materials, or metallic alloys by way of non-limiting examples.

The connector body 108 may be one of a plurality of connector bodies. The connector body 108 is slidably received through the plurality of longitudinal apertures 136 and by the plurality of longitudinal recesses 138. The connector body 108 may mechanically couple the injector holder 102, the reactor flange 104, and the coupling member 106 such that the injector protrusion 118 and the reactor protrusion 130 may cause deformation of the coupling member 106 at the protrusions. As will be appreciated by those skilled in the art, in addition to deformation of the coupling member 106 at the protrusions, the coupling member 106 may also undergo compression, by the injector holder 102 and the reactor flange 104, as the connector body 108 is seated further in the injector rim 116. This compression may further increase the sealing properties of the coupling member 106.

In the illustrated example, the plurality of longitudinal apertures 136 are defined by the injector rim 116 while the plurality of longitudinal recesses 138 are defined by the reactor rim 128. In certain examples, the plurality of longitudinal apertures 136 may be defined by the reactor rim 128 and the plurality of longitudinal recesses 138 may be defined by the injector rim 116 and still remain within the scope of the present disclosure. The longitudinal apertures 136 may be threaded or free of threading to slidably receive the connector body 108 and the longitudinal recesses 138 may be threaded. Although shown and described herein as resembling a "bolt" for the connector body 108, the connector body 108 may include other techniques of coupling the injector holder 102, the reactor flange 104, and the coupling member 106. It is contemplated that the connector body 108 may be formed from a refractory material 148. It is contemplated that the connector body 108 may be formed from a metallic material. It is contemplated that the connector body 108 may be formed from silicon (Si), quartz, silicon carbide (SiC), aluminum oxide (Al₂O₃), stainless steel, or metal alloys, by way of non-limiting examples.

In the illustrated example the injector holder 102, the reactor flange 104, and the coupling member 106, couple the precursor source 202 to the hollow interior 226 of the chamber body 220, via the precursor supply conduit 210, the supply aperture 236, the precursor aperture 134, and the injector 234 (as shown in FIG. 2), such that the material layer precursor 10 may be deposited onto the substrates 2 and a material layer 4 may be formed. As will be appreciated by those skilled in the art, the precursor aperture 134, the reactor aperture 132, and the injection aperture 120 may be aligned such that the material layer precursor 10 flows with minimal disturbance through the injector apparatus 100. Decreasing the disturbance of the material layer precursor 10 flow may improve the uniformity of the material layer 4 formed on the substrates 2.

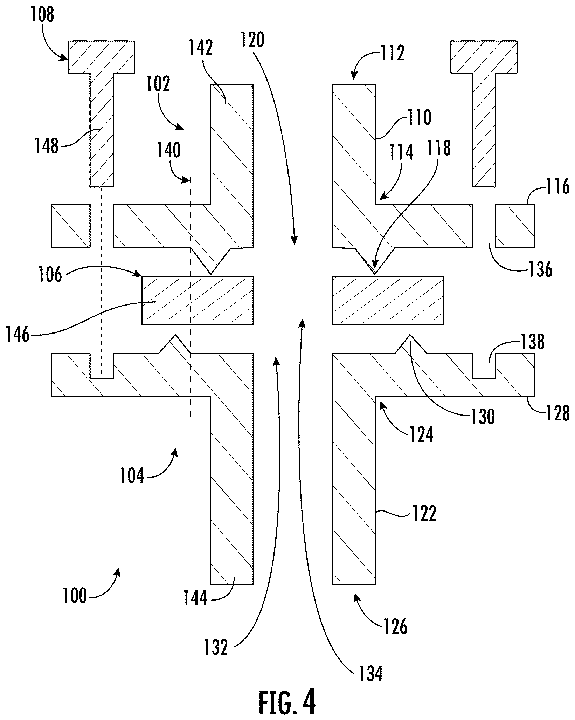

As shown in FIG. 4, a longitudinal cross-sectional exploded view of the injector apparatus 100 is shown where the connector body 108 is slidably received through the plurality of longitudinal apertures 136 and by the plurality of longitudinal recesses 138, and the connector body 108 would be seated in the injector rim 116. In certain examples, the plurality of longitudinal apertures 136 may be defined by the reactor rim 128, the plurality of longitudinal recesses 138 by the injector rim 116, and the connector body 108 is seated in the reactor rim 128 of the reactor flange 104.

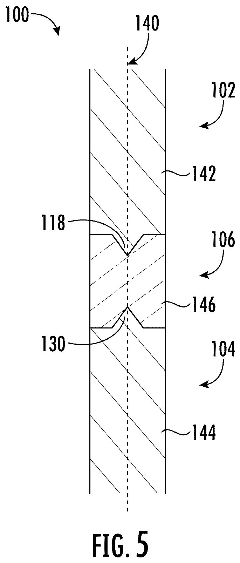

As shown in FIG. 5, a partial lateral cross-sectional view of the injector apparatus 100 is shown. In the illustrated example, upon the coupling of the injector holder 102, the coupling member 106, and the reactor flange 104 by the connector body 108, the injector protrusion 118 and the reactor protrusion 130 may cause deformation of the coupling member 106 along the vertical dashed line 140. Although shown and described herein as having both the injector protrusion 118 and the reactor protrusion 130 aligned along the vertical dashed line 140, one or neither of the injector protrusion 118 or the reactor protrusion 130 may not be aligned along the vertical dashed line 140 and still remain within the scope of the present disclosure. As will be appreciated by those skilled in the art, the injector protrusion 118 and the reactor protrusion 130 may be aligned along the vertical dashed line 140 in the lateral view but not in the longitudinal view and vice versa and remain within the scope of the current disclosure. In certain examples both the injector protrusion 118 and the reactor protrusion 130 may be aligned along the vertical dashed line 140 in both the lateral and longitudinal view and remain within the scope of the current disclosure.

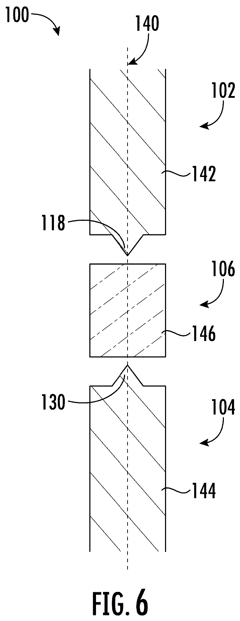

As shown in FIG. 6, a partial lateral cross-sectional exploded view of the injector apparatus 100 is shown. In the illustrated example the injector protrusion 118 and the reactor protrusion 130 are shown extending from the injector rim 116 and the reactor rim 128, respectively. Additionally, the coupling member 106 is shown not pre-shaped or pre-formed to receive either the injector protrusion 118 or the reactor protrusion 130. As will be appreciated by those skilled in the art, the coupling member 106 may take on the geometry of the injector protrusion 118 and/or the reactor protrusion 130 as the connector body 108 couples the injector holder 102, the reactor flange 104, and the coupling member 106. As the injector holder 102, the reactor flange 104 and the coupling member 106 are coupled together, by the connector body 108, the coupling member 106 is compressed. The injector protrusion 118 along with the reactor protrusion 130 cause deformation of the coupling member 106 resulting in an improved seal of the injector apparatus 100. The compression and deformation of the coupling member 106 may be in part due to the material selected for the coupling member 106, e.g., the malleable material 146.

With reference to FIG. 7, the material layer deposition method 300 is shown. The material layer deposition method 300 may include the connector body mechanically coupling the injector holder to the reactor flange with the coupling member therebetween, e.g., the connector body 108 slidably received through the plurality of longitudinal apertures 136 and received by the plurality of longitudinal recesses 138 (as shown in FIG. 3). The material layer deposition method 300 may also include seating a workpiece within the chamber body, e.g., the substrate 2 within the chamber body 220 (as shown in FIG. 2), as shown with box 302. The material layer deposition method 300 may further include heating the workpiece within the chamber body to a predetermined material layer deposition temperature, e.g., applying power to the array of heating elements 222 such that they generate electromagnetic radiation within an infrared waveband (as shown in FIG. 2), as shown with box 304. The material layer deposition method 300 may additionally include exposing the workpiece to a material layer precursor within the chamber body, e.g., exposing the substrate 2 (as shown in FIG. 2) to the material layer precursor 10 (as shown in FIG. 2), and depositing a material layer onto the workpiece using the material layer precursor, e.g., depositing the material layer 4 (as shown in FIG. 2) using the material layer precursor 10, as shown with box 306 and box 308.

Seating 302 the workpiece in the chamber body may include opening a moveable door beneath the pedestal, e.g., the moveable door 246 supporting the pedestal 232 (as shown in FIG. 2), and inserting the substrate support with one or more workpieces seated in the substrate support into the chamber body, e.g., the substrate support 230 with multiple substrates 2 (as shown in FIG. 2), as shown by box 302. The movable door may thereafter be closed. Seating 302 the workpiece may include opening the moveable door beneath the pedestal and inserting a workpiece directly into chamber body. Seating 302 of the workpiece into the chamber body may be accomplished using the controller, e.g., using instructions recorded in one or more of the plurality of program modules 254 on the memory 256 to open the movable door, seat the one or more workpieces in the substrate support, raise the substrate support into the chamber body, and close the movable door.

Heating 304 the workpiece to the predetermined material layer deposition temperature may include radiantly communicating heat into the interior of the chamber body, as shown by box 304. Radiant heating may be accomplished by generating electromagnetic radiation within an infrared waveband from a heater element supported outside of the chamber body and transmitted through a ceramic material forming the chamber body, e.g., generated using the array of heating elements 222 (as shown in FIG. 2) and transmitted through the ceramic material 228 (as shown in FIG. 2) forming the chamber body 220. Heating 304 the workpiece may also include detecting the temperature of the workpiece using a temperature sensor array and communicating a signal to the controller, e.g., the one or more temperature sensors 224 in communication with the controller 208 via the wired or wireless link 216, communicating the temperature of the substrate 2 (as shown in FIG. 2). Heating 304 the workpiece within the chamber body may be accomplished using the controller, e.g., using instructions recorded in one or more of the plurality of program modules 254 recorded on the memory 256 of the controller 208, to control the array of heating elements, receive a signal from the temperature sensor, or adjust the output provided to the heater element array based upon the signal received from the temperature sensor.

Exposing 306 the workpiece to the material layer precursor may include exposing the workpiece to a silicon-containing material layer precursor, such as a non-chlorinated silicon-containing material layer precursor like silane (SiH₄) or disilane (Si₂H₆) and/or a halogenated, e.g. chlorinated silicon-containing material layer precursor such as dichlorosilane (H₂SiCl₂) or trichlorosilane (HCl₃Si). Other material layer precursors include metallic precursor, organometallic precursors, and halides. In some embodiments, a material layer precursor can comprise one or more elements selected from hydrogen, an alkaline metal, an alkaline earth metal, a transition metal, a lanthanide, a post transition metal, a group 13 element, a group 14 element, a chalcogen, a pnictogen, a halogen, and a noble gas. Exposing 306 the workpiece to the material layer precursor may include exposing the workpiece to a dopant-containing material layer precursor or an alloying-containing material layer precursor, such as an n-type dopant-containing material layer precursor including arsine (As) or phosphorous (P) or a p-type dopant-containing material layer precursor including boron (B) as well as a germanium-containing material layer precursor such as germane (GeH₄). Exposing 306 the workpiece to the material layer precursor may include exposing the substrate to an etchant, such a chlorinated etchant like hydrochloric (HCl) acid or chlorine (Cl₂) gas or a fluorinated composition like hydrofluoric (HF) acid. Exposing 306 the workpiece to the material layer precursor may include co-flowing a carrier or diluent fluid with the material layer precursor, such as hydrogen (H₂) gas or nitrogen (N₂) gas. It is contemplated that exposing 306 the workpiece to the material layer precursor may include exposing the workpiece to a mixture including a silicon-containing material layer precursor, a dopant-containing material layer precursor, an etchant, and a carrier or diluent fluid. It is also contemplated that exposing 306 the workpiece to the material layer precursor may be accomplished using the controller, e.g., using instructions recorded in one or more of the plurality of program modules 254 recorded on the memory 256 to control the material layer precursor 10 flow from the precursor source 202 into the injector apparatus 100 then into the injector 234.

Depositing 308 the material layer onto the workpiece may include depositing a material layer that is near uniform onto the workpiece, e.g., the material layer 4 deposited onto the substrate 2 (as shown in FIG. 2). Depositing 308 the material layer may include depositing a silicon-containing material layer, such as an intrinsic silicon material layer or a silicon-germanium as well as a doped silicon-containing material layer. Depositing 308 the material layer may include depositing a non-chlorinated silicon-containing material layer precursor like silane (SiH₄) or disilane (Si₂H₆) and/or a halogenated, e.g. chlorinated silicon-containing material layer precursor such as dichlorosilane (H₂SiCl₂) or trichlorosilane (HCl₃Si). Depositing 308 the material layer may include depositing other material layer precursors including metallic precursor, organometallic precursors, and halides. Depositing 308 the material layer may include depositing a one or more elements selected from hydrogen, an alkaline metal, an alkaline earth metal, a transition metal, a lanthanide, a post transition metal, a group 13 element, a group 14 element, a chalcogen, a pnictogen, a halogen, and a noble gas. Depositing 308 the material layer may include depositing a dopant-containing material layer precursor or an alloying-containing material layer precursor, such as an n-type dopant-containing material layer precursor including arsine (As) or phosphorous (P) or a p-type dopant-containing material layer precursor including boron (B) as well as a germanium-containing material layer precursor such as germane (GeH₄). It is contemplated that controlling the deposition of the material layer may be controlled using the controller, e.g., using instructions recorded in one or more of the plurality of program modules 254 recorded on the memory 256 to control the material layer precursor 10 flow from the precursor source 202 into the injector apparatus 100 then into the injector 234.

Although this disclosure has been provided in the context of certain embodiments and examples, it will be understood by those skilled in the art that the disclosure extends beyond the specifically described embodiments to other alternative embodiments and/or uses of the embodiments and obvious modifications and equivalents thereof. In addition, while several variations of the embodiments of the disclosure have been shown and described in detail, other modifications, which are within the scope of this disclosure, will be readily apparent to those of skill in the art based upon this disclosure. It is also contemplated that various combinations or sub-combinations of the specific features and aspects of the embodiments may be made and still fall within the scope of the disclosure. It should be understood that various features and aspects of the disclosed embodiments can be combined with, or substituted for, one another in order to form varying modes of the embodiments of the disclosure. Thus, it is intended that the scope of the disclosure should not be limited by the particular embodiments described above. The illustrations presented herein are not meant to be actual views of any particular material, structure, or device, but are merely idealized representations that are used to describe embodiments of the disclosure.

The headings provided herein, if any, are for convenience only and do not necessarily affect the scope or meaning of the devices and methods disclosed herein.

## Claims

1. An injector apparatus, comprising:
an injector holder further comprising:
an injector collar having a first injector collar end and a second injector collar end; and
an injector rim coupled to the first injector collar end and defining an injection aperture;
an injector slidably received by the second injector collar end;
a reactor flange further comprising:
a tube member having a first tube member end and a second tube member end; and
a reactor rim coupled to the first tube member end and defining a reactor aperture;
a coupling member fluidly coupling the reactor flange to the injector holder and defining a precursor aperture;
a connector body configured to mechanically couple the injector holder to the reactor flange; and
at least one of an injector protrusion and a reactor protrusion, the injector protrusion extending from the injector rim about the injection aperture, and the reactor protrusion extending from the reactor rim about the reactor aperture.

2. The injector apparatus of claim 1, further comprising the injector protrusion and the reactor protrusion.

3. The injector apparatus according to any of claims 1 to 2, further comprising:
the injector rim further defining a plurality of longitudinal apertures radially outward of the injector protrusion;
the reactor rim defining a plurality of longitudinal recesses radially outward of the reactor protrusion; and
the connector body seated in the injector rim slidably received by the plurality of longitudinal apertures and coupling to the plurality of longitudinal recesses.

4. The injector apparatus according to any of claims 1 to 2, further comprising:
the injector rim further defining a plurality of longitudinal recesses radially outward of the injector protrusion;
the reactor rim defining a plurality of longitudinal apertures radially outward of the reactor protrusion; and
the connector body seated in the reactor rim slidably received by the plurality of longitudinal apertures and coupling to the plurality of longitudinal recesses.

5. The injector apparatus according to any of claims 1 to 4, wherein the injector holder is comprised of a refractory material and the reactor flange is comprised of a refractory material.

6. The injector apparatus according to any of claims 1 to 5, wherein the coupling member is a malleable material.

7. The injector apparatus according to any of claims 1 to 6, wherein the connector body is one of a plurality of connector bodies and is comprised of a refractory material.

8. An injector holder, comprising:
an injector collar having a first injector collar end and a second injector collar end;
an injector rim coupled to the first injector collar end of the injector collar and defining an injection aperture; and
an injector protrusion extending from the injector rim about the injection aperture.

9. The injector holder of claim 8, further comprising an injector slidably received by the second injector collar end of the injector holder.

10. The injector holder according to any of claims 8 to 9, further comprising the injector rim further defining a plurality of longitudinal apertures radially outward of the injector protrusion.

11. The injector holder according to any of claims 8 to 9, further comprising the injector rim further defining a plurality of longitudinal recesses radially outward of the injector protrusion.

12. The injector holder according to any of claims 8 to 11, wherein the injector holder is comprised of a refractory material.

13. A reactor flange, comprising:
a tube member having a first tube member end and a second tube member end;
a reactor rim coupled to the first tube member end of the tube member and defining a reactor aperture; and
a reactor protrusion extending from the reactor rim about the reactor aperture.

14. The reactor flange of claim 13, further comprising a precursor source fluidly coupled to the second tube member end of the reactor flange.

15. The reactor flange according to any of claims 13 to 14, further comprising the reactor rim further defining a plurality of longitudinal recesses radially outward of the reactor protrusion.

16. The reactor flange according to any of claims 13 to 14, further comprising the reactor rim further defining a plurality of longitudinal apertures radially outward of the reactor protrusion.

17. The reactor flange according to any of claims 13 to 16, wherein the reactor flange is comprised of a refractory material.

18. A semiconductor processing system, comprising:
an injector apparatus according to any of claims 1 to 7;
a precursor source fluidly coupled to the injector apparatus;
a chamber body having a hollow interior;
an exhaust source fluidly coupled to the chamber body, fluidly coupled to the precursor source through the chamber body;
a substrate support positioned within the hollow interior of the chamber body;
a workpiece supported on the substrate support; and
a controller operatively connected to the precursor source and disposed in communication with the precursor source, the controller responsive to instructions recorded on a memory to deposit a material layer onto the workpiece.

19. A method of depositing a material layer onto a workpiece, comprising:
at a semiconductor processing system including the workpiece arranged within an interior of a chamber body and an injector apparatus including an injector holder having an injector protrusion; a reactor flange have a reactor protrusion; a coupling member; and a connector body configured to mechanically couple the injector holder, the coupling member, and the reactor flange, the connector body configured to compress the coupling member between the injector holder and the reactor flange;
seating the workpiece within the interior of the chamber body;
heating the workpiece to a predetermined material layer deposition temperature;
exposing the workpiece to a material layer precursor; and
depositing the material layer onto the workpiece using the material layer precursor.

20. The method of claim 19, further comprising inserting a substrate support within the interior of the chamber body, wherein the workpiece is seated on the substrate support, and wherein the workpiece is a substrate.
